# EUROPEAN PATENT APPLICATION

(11) **EP 3 561 850 A1**
(43) Date of publication of application: **30.10.2019**
(21) Application number: 18169706.1
(22) Date of filing: 27.04.2018
(51) Int. Cl.: H01J 37/073, H01J 37/075, H01J 1/20, H01J 1/34

(54) **ELECTRON EMITTING APPARATUS AND METHOD FOR EMITTING ELECTRONS**

(71) Applicant: Friedrich-Alexander-Universität Erlangen-Nürnberg, 91054 Erlangen (DE); National Institute for Materials Science, Ibaraki 305-0047 (JP)
(72) Inventor: Hommelhoff, Peter, 91052 Erlangen (DE); Zhang, Han, Ibaraki 305-0047 (JP); Li, Ang, 91054 Erlangen (DE); Tang, Jie, Ibaraki 305-0047 (JP)
(74) Representative: Fink Numrich Patentanwälte PartmbB

(57) **Abstract**

The invention refers to an electron emitting apparatus, comprising a cathode (3) and an anode (4), both disposed in a vacuum chamber (1), where the apparatus is configured to apply a voltage difference between the cathode (3) and the anode (4) such that the cathode (3) has a negative potential (Uₜᵢₚ) relative to the anode (4), the cathode (3) comprising a nanowire made of metal hexaboride, the nanowire having an apex for emitting electrons therefrom. The invention is characterized in that the electron emitting apparatus comprises a laser device (7, 8) for generating a laser beam (LB) and directing the laser beam (LB) onto the apex of the nanowire, where the laser beam (LB) triggers the emission of electrons from the apex when the cathode (3) has the negative potential (Uₜᵢₚ) relative to the anode (4).

## Description

The invention refers to an electron emitting apparatus and a method for emitting electrons.

Electron emitters are widely used for a wide variety of applications. For example, in electron microscopy, an electron emitter (often referred to as electron gun when combined with classical electron optics) is used in order to produce an electron beam which is directed towards a sample where the scattered electrons resulting from the interaction of the beam with the sample is detected and used to derive information about the sample, e.g. its surface topology.

Electron emitters produce an electron beam in a vacuum chamber by the emission of electrons from a cathode set to a negative potential. A common material for the cathode is tungsten.

Documents [1] and [2] describe a special LaB₆ nanowire for use as a cathode in an electron emission apparatus. The resulting electron emission is very stable with a high electron beam brightness. The method of electron emission for the LaB₆ nanowire described therein is DC-field emission (DC = direct current) where the emission is solely triggered by applying a high voltage to the cathode.

An alternative method to DC-field emission is laser-triggered electron emission, in which laser light incident upon a cathode yields emitted electrons. The physical mechanism for this electron emission is mainly based on photoemission and is different from the physical mechanism for DC-field emission which is based on tunneling.

It is an object of this invention to provide an alternative apparatus and method for electron emission producing a stable electron beam having a high brightness.

This object is solved by the electron emitting apparatus according to claim 1 and the method for emitting electrons according to claim 15. Preferred embodiments of the invention are defined in the dependent claims.

The electron emitting apparatus according to the invention comprises a cathode and an anode, both positioned in a vacuum chamber, where the apparatus is configured to apply a voltage difference between the cathode and the anode such that the cathode has a negative potential relative to the anode. Preferably, this voltage difference is generated by a voltage source between the anode and the cathode. The cathode comprises a nanowire made of metal hexaboride, the nanowire having an apex for emitting electrons therefrom. The term nanowire refers to a wire with a maximum extension in cross-section in the range of nanometers.

The electron emitting apparatus further comprises a laser device for generating a laser beam and directing the laser beam onto the apex of the nanowire. In other words, the laser device comprises a laser source for generating the laser beam. In one embodiment, this laser beam points directly at the apex of the nanowire. Optionally, the laser device includes one or more optical elements in addition to the laser source, such as mirrors, in order to deflect and preferably focus the laser beam so that the beam points at the apex of the nanowire. In a preferred embodiment, the laser beam points at the apex of the nanowire in a direction substantially perpendicular to the longitudinal direction of the nanowire. Preferably, the laser beam is linearly polarized with a polarization parallel to the longitudinal direction of the nanowire.

The laser beam triggers the emission of electrons from the apex of the nanowire when the cathode has the negative potential relative to the anode, i.e. when the above voltage difference is applied between the cathode and the anode. In other words, when the electron emitting apparatus is in operation, the negative potential is chosen such that the emission of electrons will only be initiated in case that the laser beam points at the apex. The value of the negative potential depends on the particular configuration of the electron emitting apparatus. Typically, the absolute value of the negative potential is in the range of one or several hundred volts in a configuration without a suppressor electrode. Embodiments of the invention with and without a suppressor electrode will be described later. In an embodiment comprising a suppressor electrode, the absolute value of the negative potential can be much higher (e.g. in the range of several and particularly tens or hundreds of kilovolts).

The electron emitting apparatus according to the invention is based on the finding that a metal hexaboride nanowire which generates a stable electron beam with substantially no emission decay over time and high beam brightness for DC-field electron emission may also be used in an apparatus based on laser-triggered electron emission. This finding could not be expected because the physical mechanism behind DC-field electron emission is different from the physical mechanism behind laser-triggered electron emission. As mentioned above, DC-field electron emission is based on tunneling whereas laser-triggered electron emission is mainly based on photoemission or multiphoton-emission. Multiphoton-emission is a variant of the photoelectric effect but with more than one photon liberating the electron from the nanowire. Furthermore, for specific laser beam parameters used for laser-triggered electron emission, the laser beam may also heat the electrons in the metal hexaboride such that thermionic electron emission may also take place.

In a preferred embodiment of the invention, the nanowire used in the electron emitting apparatus is a rare-earth metal hexaboride nanowire and preferably a nanowire made of LaB₆.

In another preferred embodiment, the nanowire is a monocrystal extending in a <100> direction according to the Miller indices. Furthermore, the nanowire preferably has a metal-terminated (100) plane according to the Miller indices. This plane consists of La atoms in the case that the nanowire is made of LaB₆. In another preferred embodiment, the apex of the nanowire has a substantially hemispherical form. In another preferred variant, the nanowire has a maximum extension in cross-section between 10 nm and 300 nm (nm = nanometer). Particularly, the nanowire extends from the apex to a cylindrical rod having a diameter in the range of 10 nm to 300 nm.

In a particularly preferred embodiment, the metal hexaboride nanowire combines the following of the above-mentioned properties:
- the nanowire is made of LaB₆;
- the nanowire is a monocrystal extending in a <100> direction;
- the nanowire has a (100) plane terminated by La atoms;
- the apex of the nanowire has a substantially hemispherical form;
- the nanowire has a maximum extension in cross-section between 10 nm and 300 nm.

Such nanowires are well-known from prior work. Those nanowires as well as a method for fabricating the same are disclosed in the above-mentioned documents [1] and [2]. The whole disclosure of those documents is incorporated by reference in this application.

In one variant of the electron emitting apparatus according to the invention, the laser device is configured to generate a laser beam in the form of a cw laser beam (cw = continuous wave). In other words, the laser device continuously generates the laser beam.

In another variant of the invention, the electron emitting apparatus comprises a suppressor electrode disposed adjacent to the cathode, the apparatus being configured to apply a voltage difference between the suppressor electrode and the anode such that the suppressor electrode has a negative potential relative to the anode. The suppressor electrode suppresses the electric field at the apex of the nanowire. This enables to apply higher negative potentials (i.e. negative potentials with higher absolute voltage values) to the nanowire relative to the anode without damaging the nanowire. The use of a higher negative potential results in a stronger acceleration of the electrons being emitted from the nanowire in the vicinity of its apex and, thus, in an electron beam having a higher beam energy.

In another preferred embodiment of the invention, the laser device is configured to generate a pulsed laser beam comprising successive laser pulses. Preferably, the pulse duration of a respective laser pulse is 100 ns (ns = nanosecond) or less. In a particularly preferred embodiment, the pulse duration of the laser pulse is 1 ps (ps = picosecond) or less. Most preferably, the pulse duration of a respective laser pulse lies between 1 fs and 500 fs (fs = femtosecond). As a general rule, the laser pulses are preferably so-called ultrashort laser pulses, a standard term in laser technology. In another preferred embodiment, the pulse duration of a respective laser pulse is between 1 to 10 cycles according to the laser light frequency of the laser beam, i.e. the length of a cycle in seconds is the inverse of the frequency in Hz.

Depending on the circumstances, the pulse energy and the fluence (energy per area) of a respective laser pulse can be chosen differently. In a preferred embodiment, the pulse energy is between 1 pJ and 100 nJ, particularly between 100 pJ and 100 nJ (pJ = pico-joule, nJ = nanojoule). Preferably, the pulse energy lies between 10 nJ and 40 nJ where this value range is preferably used for a laser wavelength between 2 µm and 3 µm (µm = micrometer) with a focal spot size (Gaussian waist) of the laser beam between 10 µm and 15 µm. In another preferred embodiment, the peak fluence (highest fluence value occurring within the laser beam profile) of a respective laser pulse is between 10⁻⁵ J/m² and 10⁷ J/m², particularly between 10⁻¹ J/m² and 10⁴ J/m².

In another preferred embodiment, the laser device is configured to focus the laser beam at the apex of the nanowire. Preferably, the focal spot size (Gaussian waist) of the laser beam at the position of the apex is between hundreds of nanometers and tens of microns, e.g. 13 µm.

Depending on the circumstances, the laser device can generate laser beams with different wavelengths. E.g., the wavelength of the laser beam can lie in the visible spectrum but can also be either in the ultraviolet or the infrared.

In another embodiment of the invention, the electron emitting apparatus includes a means for adjusting the position of the laser beam relative to the nanowire. For example, a mirror can be used to direct the laser beam towards the cathode. The adjusting means is preferably combined with a detecting means for detecting the position of the laser beam with respect to a mounting element for the nanowire. For example, the detection means is a camera detecting the laser beam. The detection means facilitates the adjustment of the laser beam such that this beam is directed onto the apex of the nanowire.

The electron emitting apparatus according to the invention can be used as an electron source in various equipment. In a particularly preferred embodiment, the electron emitting apparatus is an electron source for an electron gun for an electron microscope, particularly a scanning electron microscope or a transmission electron microscope. In other words, the invention also refers to an electron microscope comprising an electron gun with an electron source in the form of the electron emitting apparatus according to the invention or one or more preferred embodiments of the invention. Nevertheless, the electron emitting apparatus according to the invention may also be used in particle accelerators, medical devices and in other fields of applications.

Moreover, the invention includes a method for emitting electrons using the electron emitting apparatus according to the invention or one or more preferred embodiments thereof. That is, the features of each preferred embodiment of the apparatus may also be present in the corresponding variant of the method. According to the method of the invention, a laser beam is generated and directed onto the apex of the nanowire by the laser device of the apparatus when the cathode has the negative potential relative to the anode, where the laser beam triggers the emission of electrons from the apex.

In the following, an embodiment of the invention will be described in detail with respect to the accompanying drawings wherein:
- Fig. 1: is a schematic illustration of a variant of an electron emitting apparatus according to the invention; and
- Fig. 2: is a schematic illustration of another embodiment of an electron emitting apparatus according to the invention.

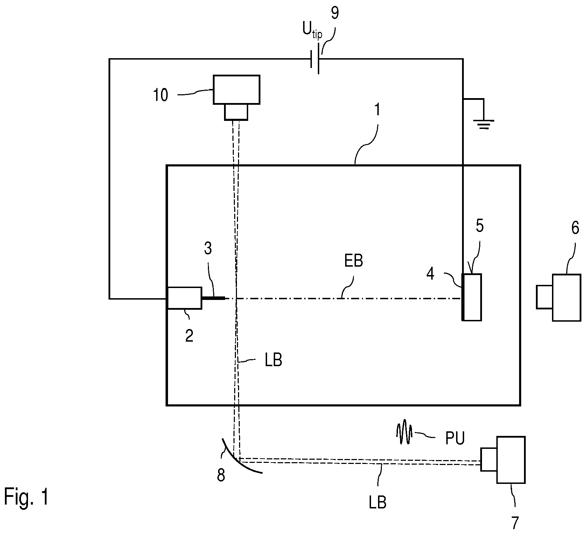

The electron emitting apparatus as shown in Fig. 1 comprises a vacuum chamber 1, i.e. a chamber which is evacuated during operation of the electron emitting apparatus. Preferably, a high vacuum (pressure less than 10⁻³ torr) or an ultra-high vacuum (pressure of 10⁻⁸ torr or less) is produced in the chamber. A cathode 3 as well as an anode 4 are positioned within the chamber. The cathode and the anode are connected to a voltage source 9 which applies a negative voltage Uₜᵢₚ to the cathode 3, i.e. the negative pole of voltage source 9 is connected to the cathode 3 whereas the positive pole of the voltage source 9 is connected to the anode 4. The anode is grounded in the embodiment of Fig. 1. The cathode 3 is a LaB₆ nanowire attached to a mounting member 2 in the form of a metal needle which is preferably made of tungsten or tantalum. Generally, the needle material needs to tolerate a short time of heating up to approximately 700°C. To prevent reaction between the nanowire and the needle, an inert metal like Ta or a reactive material with inert coating, such as C coating, can be used. Hence, there is a wide variety of possible compositions for the needle material.

The nanowire 3 as well as the assembly comprised of the nanowire 3 and the needle 2 were prepared as described in documents [1] and [2]. To do so, the nanowire which is for example fabricated by a chemical vapor deposition process as described in document [3] is at first subjected to a field evaporation process, i.e. a positive voltage is applied to the nanowire under low pressure or vacuum resulting in a field evaporation of atoms from the nanowire. Preferably, this field evaporation is performed under the presence of an atmosphere containing trace amounts of H₂. This field evaporation shapes the apex of the LaB₆ nanowire into a substantially hemispherical form. In a next step, the nanowire is activated by once again applying a positive voltage to the nanowire under vacuum with or without trace amounts of Ne gas. As a consequence, the positively charged La atoms settle onto the apex surface of the LaB₆ nanowire. The nanowire thus prepared is a monocrystal made of LaB₆ extending in the <100> direction and having a (100) plane on its apex terminated by La atoms. The diameter of this nanowire lies in the range between 10 nm to 300 nm. For example, a nanowire of 30 nm can be used in the apparatus as shown in Fig. 1. To connect this nanowire 3 with the needle 2, the nanowire is fixed onto the needle by carbon bonding using an electron beam deposition process.

In operation of the electron emission apparatus of Fig. 1 (usually at room temperature), the assembly of the needle 2 and the nanowire 3 is subjected to the negative voltage Uₜᵢₚ as mentioned above. The voltage is set such that, without directing a laser beam onto the apex of the nanowire 3, no electron emission occurs from the apex of the nanowire. The appropriate voltage Uₜᵢₚ to be applied to the nanowire depends on the actual configuration of the electron emitting apparatus and particularly on the distance between the nanowire 3 and the anode 4. Usually, a negative voltage of one hundred to several hundred volts is applied to the nanowire 3. In an experiment conducted by the inventors, a negative voltage having an absolute value of less than 180 V for a distance of 95 mm between the cathode and the anode was used. In this experiment, the threshold voltage for a DC-field emission (i.e. electron emission solely based on the voltage between anode and cathode without laser-triggering) is at approximately -185 V. I.e., applying a negative voltage having an absolute value of 185 V and more will cause a DC-field emission.

The apparatus as shown in Fig. 1 produces electron emission from the LaB₆ nanowire 3 based on laser-triggering, i.e. the electron emission apparatus is a laser-triggered electron source having a wide variety of applications, e.g. as an electron gun in an electron microscope. For performing laser-triggering, the apparatus of Fig. 1 comprises a conventional laser 7, i.e. a laser source producing a laser beam LB. The contour of this laser beam is indicated in Fig. 1 by dashed lines. In the embodiment described herein, the laser source 7 produces a pulsed laser beam, i.e. a laser beam comprising successive laser pulses. This is schematically illustrated in Fig. 1 by a pulse having reference numeral PU. The laser pulses produced by the laser source 7 are so-called ultrashort laser pulses having a pulse duration in the range of picoseconds or less. Preferably, the pulse duration is chosen to be between 50 fs and 500 fs. The wavelength of the laser light can be chosen differently (e.g. visible, infrared or ultraviolet light). In one experiment conducted by the inventors, the laser source 7 produced infrared laser pulses with a wavelength of 2650 nm.

The laser beam LB produced by the laser 7 is directed towards an off-axis parabolic mirror 8. In the embodiment of Fig. 1, no additional optical elements are disposed between the laser source 7 and the parabolic mirror 8. However, in other embodiments, the laser source 7 can be oriented differently where the laser beam is deflected by one or more mirrors in order to be directed to the off-axis parabolic mirror 8. The off-axis parabolic mirror 8 is arranged such that the laser beam LB enters the vacuum chamber 1 through a transparent portion of the chamber (i.e. a window) and is focused on the apex of the nanowire 3, where the laser beam reaches the apex in a direction substantially perpendicular to the longitudinal axis of the nanowire 3. Preferably, the diameter or spot size (Gaussian waist) of the laser beam at the location of the apex is between hundreds of nanometers and tens of microns, e.g. 13 µm. Instead of a focusing mirror, other focusing elements such as a focusing lens may also be used.

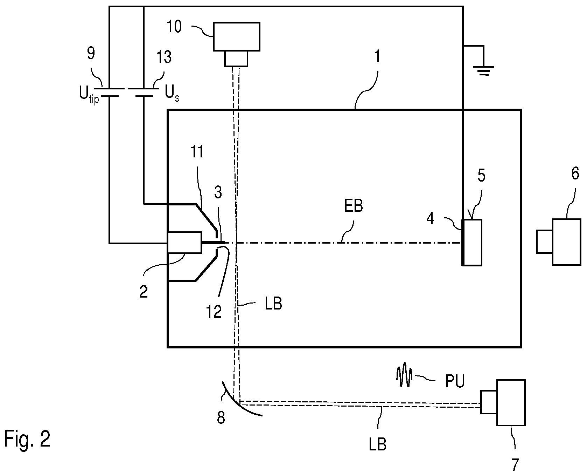

The laser beam LB directed onto the apex of the nanowire 3 results in the emission of an electron beam EB which is indicated by a dash-dotted line in Fig. 1. The electron beam is accelerated towards the anode 4 which is the front plate of a micro-channel plate detector 5. Such detectors are well-known from the prior art and comprise several micro-channel plates. The detector 5 shown in Fig. 1 and Fig. 2 has a phosphor plate at its end opposite to the end where the anode 4 is located. A camera 6 placed behind the detector 5 outside the chamber 1 is used in order to detect the electron beam EB. The micro-channel plates of the detector 5 intensify the signal of the electron beam where the intensified signal falls on the phosphor plate. The light from this phosphor plate is detected by the camera 6.

The combination of the micro-channel plate detector 5 and the camera 6 are used in order to diagnose properties of the electron beam EB, particularly the electron emission current and the electron energy spread. When using the electron emitting apparatus in commercial equipment, such as an electron microscope, the micro-channel plate detector 4 and the camera 6 will not be positioned at the positions as shown in Fig. 1. Particularly, when using the apparatus of Fig. 1 as an electrode source in an electron gun in electron microscopy, the vacuum chamber 1 would extend beyond the anode 4 in the horizontal direction of Fig. 1 in order to position further components of the electron microscope behind the anode 4, i.e. a series of electron optics as well as the sample to be analyzed and corresponding detectors for the radiation reflected or transmitted by the sample. Furthermore, the distance between the nanowire 3 and the cathode 4 would be far less than in the embodiment of Fig. 1. In an electron gun, this distance typically lies between 0.1 mm and 1 mm whereas the distance between the nanowire and the cathode in Fig. 1 is approximately 10 cm.

In the embodiment of Fig. 1, an additional camera 10 is placed at the side of the vacuum chamber opposite to the side where the parabolic mirror 8 is arranged. This camera is positioned adjacent to a transparent portion (i.e. a window) of the chamber and senses the laser beam LB having passed the nanowire 3. The position of the parabolic mirror 8 can be adjusted in order to move the laser beam LB such that the beam points at the apex of the nanowire 3. However, the nanowire 3 is not visible by the human eye and cannot be detected by the camera 10 due to its insufficient resolution. Therefore, the mirror 8 is at first roughly adjusted such that the laser beam is at the tip of the needle 2. This can be confirmed by the images taken by the camera 10. Thereafter, the beam is moved in the longitudinal direction of the wire 3 by adjusting the mirror 8, i.e. the beam moves from the tip of the needle 2 to the right. As soon as an electron beam EB is detected by camera 6 during this adjusting process, this position of the beam is maintained because the beam has then roughly reached the apex of the nanowire 3.

Fig. 2 shows a modification of the embodiment of Fig. 1. The only difference between Fig. 1 and Fig. 2 resides in the use of an additional suppressor electrode 11 positioned inside the chamber 1 around the assembly of the needle 2 and the nanowire 3. A negative voltage Uₛ is applied to this suppressor electrode by the additional voltage source 13. The absolute value of this voltage Uₛ is similar to the absolute value of the voltage Uₜᵢₚ. The suppressor electrode 11 has a tapered section and encloses the needle 2. A hole 12 is provided at one end of the suppressor electrode. The nanowire 3 extends through this hole. The potential applied to the suppressor electrode 11 suppresses the electric field at the apex of the nanowire 3. As a consequence, much higher voltages can be applied to the nanowire without damaging the nanowire. E.g., voltages in the range of tens of kilovolts can be applied to the nanowire 3. Due to the use of higher voltages, a higher acceleration gradient of the electrons emitted from the nanowire can be achieved, resulting in a higher energy of the electron beam EB. The other components shown in Fig. 2 correspond to the components of the apparatus of Fig. 1. Hence, reference is made to the description of Fig. 1 with respect to those components.

It is known that the LaB₆ nanowire used in the configurations of Fig. 1 and 2 results in very stable electron emission over several hours combined with a high electron emission current, a small transverse beam emittance and a low energy spread in the case of DC-field electron emission, i.e. without laser triggering. It could not be expected that this LaB₆ nanowire will also result in an electron emission with such good properties in case that the electron emission is triggered by laser light. This is because the physical mechanism of DC-field emission is different from the physical mechanism of laser-triggered emission.

However, the inventors could confirm by experiments performed with the configuration of Fig. 1 that a laser-triggered electron emission using an LaB₆ nanowire also produces a high electron emission current with small transverse beam emittance and low energy spread. Typically, the transverse geometrical beam emittance lies between 0.01 nm·rad and 1 nm·rad (nm·rad = nanometer times radian) and the energy spread lies between 0.1 eV and 2 eV. A laser-triggered emission with these properties was achieved for different laser wavelengths as well as different pulse durations and energies within the ranges as defined in the claims.

The invention as described in the foregoing has several advantages. Particularly, a novel laser-triggered electron emission apparatus is provided by using a LaB₆ nanowire as a cathode. This electron emission apparatus has a wide range of applications, e.g. as an electron source for electron microscopy, particle accelerators, medical devices and the like.

### List of References:

[1] US 8,952,605 B2
[2] H. Zhang, J. Tang, J. Yuan, Y. Yamauchi, T.T. Suzuki, N. Shinya, K. Nakajima, and L. Qin: "An ultrabright and monochromatic electron point source made of a LaB6 nanowire", Nature nanotechnology, 11(3): pages 273-279,2016
[3] US 8,501,136 B2

## Claims

1. An electron emitting apparatus, comprising a cathode (3) and an anode (4), both disposed in a vacuum chamber (1), where the apparatus is configured to apply a voltage difference between the cathode (3) and the anode (4) such that the cathode (3) has a negative potential (Uₜᵢₚ) relative to the anode (4), the cathode (3) comprising a nanowire made of metal hexaboride, the nanowire having an apex for emitting electrons therefrom, **characterized in that**
the electron emitting apparatus includes a laser device (7, 8) for generating a laser beam (LB) and directing the laser beam (LB) onto the apex of the nanowire, where the laser beam (LB) triggers the emission of electrons from the apex when the cathode (3) has the negative potential (Uₜᵢₚ) relative to the anode (4).

2. The electron emitting apparatus according to claim 1, **characterized in that** the nanowire is made of LaB₆.

3. The electron emitting apparatus according to claim 1 or 2, **characterized in that** the nanowire is a monocrystal extending in a <100> direction.

4. The electron emitting apparatus according to one of the preceding claims, **characterized in that** the nanowire has a metal-terminated (100) plane.

5. The electron emitting apparatus according to one of the preceding claims, **characterized in that** the apex of the nanowire has a substantially hemispherical form.

6. The electron emitting apparatus according to one of the preceding claims, **characterized in that** the nanowire has a maximum extension in cross-section between 10 nm and 300 nm.

7. The electron emitting apparatus according to one of the preceding claims, where the apparatus comprises a suppressor electrode (11) disposed adjacent to the cathode (3), the apparatus being configured to apply a voltage difference between the suppressor electrode (11) and the anode (4) such that the suppressor electrode (11) has a negative potential (Uₛ) relative to the anode (4).

8. The electron emitting apparatus according to one of the preceding claims, **characterized in that** the laser beam (LB) is a pulsed laser beam comprising successive laser pulses (PU).

9. The electron emitting apparatus according to claim 8, **characterized in that** the pulse duration of a respective laser pulse (PU) is 100 ns or less and preferably 1 ps or less and/or that the pulse duration of a respective laser pulse (PU) is between 1 to 10 cycles according to the laser light frequency of the laser beam (LB).

10. The electron emitting apparatus according to one of claims 7 to 9, **characterized in that** the pulse energy of a respective laser pulse (PU) is between 1 pJ and 100 nJ, preferably between 10 nJ and 40 nJ, and/or that the peak fluence of a respective laser pulse (PU) is between 10⁻⁵ J/m² and 10⁷ J/m², particularly between 10⁻¹ J/m² and 10⁴ J/m².

11. The electron emitting apparatus according to one of the preceding claims, **characterized in that** the laser device (7, 8) is configured to focus the laser beam (LB) at the apex of the nanowire.

12. The electron emitting apparatus according to one of the preceding claims, **characterized in that** the laser device (7, 8) is configured to generate a visible laser beam (LB) or an ultraviolet laser beam (LB) or an infrared laser beam (LB).

13. The electron emitting apparatus according to one of the preceding claims, **characterized in that** the electron emitting apparatus comprises an adjusting means for adjusting the position of the laser beam (LB) relative to the nanowire, the apparatus preferably comprising a detection means (10) for detecting the position of the laser beam with respect to a mounting element (2) for the nanowire.

14. The electron emitting apparatus according to one of the preceding claims, **characterized in that** the electron emitting apparatus is an electron source for an electron gun for an electron microscope.

15. A method for emitting electrons using an electron emitting apparatus according to one of the preceding claims, wherein a laser beam (LB) is generated and directed onto the apex of the nanowire by the laser device (7, 8) when the cathode (3) has the negative potential (Uₜᵢₚ) relative to the anode (4), where the laser beam (LB) triggers the emission of electrons from the apex.
